# EUROPEAN PATENT APPLICATION

(11) **EP 2 518 180 A2**
(43) Date of publication of application: **31.10.2012**
(21) Application number: 12166215.9
(22) Date of filing: 30.04.2012
(51) Int. Cl.: C23C 16/458, C23C 16/52, C23C 16/455, C23C 16/46

(54) **Apparatus and method for treating substrate**

(30) Priority: 29.04.2011 KR 20110040958; 04.08.2011 KR 20110077744
(71) Applicant: Semes Co., Ltd., Chungcheongnam-do 330-290 (KR)
(72) Inventor: Jung, KyungHwa, Chungcheongnam-do, 331-220 (KR)
(74) Representative: Mounteney, Simon James

(57) **Abstract**

Provided are an apparatus and method for depositing a thin film on a substrate. The substrate is supported by a substrate holder. The substrate holder is seated on each of a plurality of holder seating grooves defined in a top surface of the susceptor. An injection hole for injecting a gas is defined in a top surface of each of the holder seating grooves. When a process is performed, the susceptor is rotated with respect to a central axis thereof, and the substrate holder is rotated with respect to a central axis of the substrate holder by the gas injected from the injection hole. A flow rate of the gas supplied onto an under surface of the substrate holder is adjusted according to a state of the substrate.

## Description

### BACKGROUND

The present disclosure herein relates to an apparatus and method for treating a substrate, and more particularly, to an apparatus and method for depositing a thin film on a substrate.

To manufacturing integrated circuits (ICs) such as semiconductor chips or light emitting diodes (LEDs), processes for depositing a thin film on a substrate are required. In a metal organic chemical vapor deposition (MOCVD) process among these processes, a thin film is deposited on a substrate using gas thermal decomposition reaction of a metal organic compound and a hydrogen compound. Substrates may include sapphire (Al₂O₃) and silicon carbide (SiC) substrates used for manufacturing Epi-wafers in a process for manufacturing LEDs or silicon wafers used for manufacturing semiconductor ICs.

An apparatus in which a MOCVD process is performed to manufacture an LED includes a susceptor having a plurality of holder seating grooves in an edge thereof and substrate holders inserted into the holder seating grooves. A gas is supplied onto under surfaces of the substrate holders, and each of the substrate holders is rotated with respect to a central axis thereof. However, deposition rates of thin films deposited on substrates supported by the susceptor are different from each other. To solve this limitation, various methods for improving deposition uniformity of the thin films deposited on the substrates are required.

### [Patent Document]

Prior Document 1: U.S Patent Registration No. 6,797,069

### SUMMARY

The present disclosure provides an apparatus and method for treating a substrate which may improve deposition uniformity of thin films deposited on substrates supported by a susceptor.

Embodiments of the inventive concept provide apparatuses for treating substrates including: a chamber providing an inner space in which a treatment process is performed, the chamber having an opened upper side; a susceptor disposed within the chamber, the susceptor having a plurality of holder seating grooves in a top surface thereof, wherein an injection hole is defined in each of the holder seating grooves; a rotation shaft rotating the susceptor; a substrate holder on which each of the substrates is placed, the substrate holder being inserted into each of the holder seating grooves; a heater heating the susceptor; a gas supply line connected to the injection hole to supply a gas into the injection hole; a flow regulator disposed on the gas supply line to regulate a flow rate of the gas; a detection member detecting a state of each of the substrates placed on the substrate holder; and a control unit controlling the flow regulator according to the state detected by the detection member.

In some embodiments, the state may be a temperature of each of the substrates. The state may be a thickness of a thin film deposited on each of the substrates. The holder seating grooves may be arranged in a circular ring shape with respect to a central axis of the susceptor. The detection member may be disposed directly above any position on a revolution mark along which the holder seating grooves are rotated. When one substrate of the substrates has a temperature greater than temperatures of other substrates, the control unit may increase a flow rate of a gas supplied to the substrate holder on which the one substrate is placed, and when one substrate of the substrates has a temperature less than temperatures of other substrates, the control unit may decrease a flow rate of a gas supplied to the substrate holder on which the one substrate is placed. When a thin film deposited on one substrate of the substrates has a thickness greater than thicknesses of thin films deposited on other substrates, the control unit may increase a flow rate of a gas supplied to the substrate holder on which the one substrate is placed, and when a thin film deposited on one substrate of the substrates has a thickness less than thicknesses of thin films deposited on other substrates, the control unit may decrease a flow rate of a gas supplied to the substrate holder on which the one substrate is placed.

In other embodiments of the inventive concept, methods for treating substrates include: inserting a substrate holder, on which each of the substrates is placed, into each of a plurality of holder seating grooves formed in a top surface of a susceptor; injecting a gas through an injection hole formed in each of the holder seating grooves to rotate the substrate holder, and rotating the susceptor; detecting a state of the substrate placed on the substrate holder; and regulating a flow rate of a gas injected onto the substrate holder according to the detected state.

In some embodiments, the detecting of the state may include measuring a temperature of the substrate placed on the substrate holder. The detecting of the state may include measuring a thickness of a thin film deposited on the substrate placed on the substrate holder. In the regulating of the flow rate, when one substrate of the substrates has a temperature greater than temperatures of other substrates, a flow rate of a gas supplied to the substrate holder on which the one substrate is placed may be increased, and when one substrate of the substrates has a temperature less than temperatures of other substrates, a flow rate of a gas supplied to the substrate holder on which the one substrate is placed may be decreased. In the regulating of the flow rate, when a thin film deposited on one substrate of the substrates has a thickness greater than thicknesses of thin films deposited on other substrates, a flow rate of a gas supplied to the substrate holder on which the one substrate is placed may be increased, and when a thin film deposited on one substrate of the substrates has a thickness less than thicknesses of thin films deposited on other substrates, a flow rate of a gas supplied to the substrate holder on which the one substrate is placed may be decreased.

In still other embodiments of the inventive concept, methods for treating substrates include: forming a plurality of holder seating grooves in a top surface of a susceptor, wherein a substrate holder on which each of the substrates is placed is inserted into each of the holder seating grooves; forming an injection hole, through which a gas is injected to rotate the substrate holder, in each of the holder seating grooves; and supplying the gas injected through the injection hole to the whole or a portion of the respective holder seating grooves at flow rates different from each other.

In some embodiments, the flow rate of the gas injected through the injection hole may be different according to a state of the substrate placed on the substrate holder inserted into each of the holder seating grooves. The state may be different according to a measured temperature of each of the substrates. The state may be different according to a measured thickness of a thin film deposited on each of the substrates. The holder seating grooves may be arranged in a circular ring shape with respect to a central axis of the susceptor, and the states of the substrates may be sequentially detected by a detection member through the rotation of the susceptor.

### BRIEF DESCRIPTION OF THE DRAWINGS

The accompanying drawings are included to provide a further understanding of the inventive concept, and are incorporated in and constitute a part of this specification. The drawings illustrate exemplary embodiments of the inventive concept and, together with the description, serve to explain principles of the inventive concept. In the drawings:

FIG. 1 is a schematic sectional view of an apparatus for treating a substrate according to an embodiment of the inventive concept;

FIG. 2 is a schematic sectional view illustrating a substrate holder of FIG. 1;

FIG. 3 is a schematic plan view illustrating a susceptor of FIG. 1;

FIG. 4 is a schematic view illustrating a process of supplying a gas at different flow rates according to temperatures of substrates; and

FIG. 5 is a schematic view illustrating a process of supplying a gas at different flow rates according to thicknesses of thin films deposited on substrates.

### DETAILED DESCRIPTION OF THE EMBODIMENTS

Hereinafter, an apparatus and method for treating a substrate according to an embodiment of the inventive concept will be described in detail with reference to the accompanying drawings. Moreover, detailed descriptions related to well-known functions or configurations will be ruled out in order not to unnecessarily obscure subject matters of the present invention. Thus, in the drawings, the shapes and sizes of elements are exaggerated for clarity.

In an embodiment of the inventive concept, a metal organic chemical vapor deposition (MOCVD) apparatus used for manufacturing an LED will be described as an example of an apparatus 10 for treating a substrate. However, unlike this, the apparatus 10 for treating the substrate may be a MOCVD apparatus used for manufacturing a semiconductor chip. Also, in an embodiment of the inventive concept, a sapphire (Al₂O₃) and silicon carbide (SiC) substrate used in a process of manufacturing an LED will be described as an example of the substrate. However, unlike this, the substrate may be a silicon wafer used in a process of manufacturing a semiconductor integrated circuit (IC).

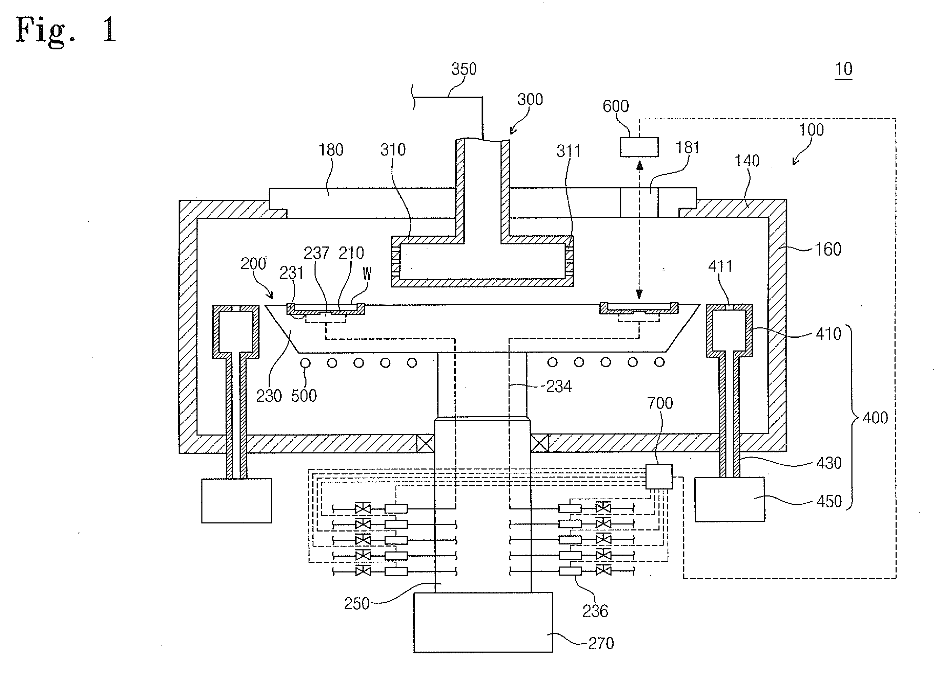

Hereinafter, an embodiment of the inventive concept will be described in detail with reference to FIGS. 1 to 7.

FIG. 1 is a schematic sectional view of an apparatus for treating a substrate according to an embodiment of the inventive concept. Referring to FIG. 1, an apparatus 10 for treating a substrate includes a chamber 100, a substrate support unit 200, an injection unit 300, an exhaust unit 400, a heater 500, a detection member 600, and a control unit 700.

The chamber 100 has a cylindrical shape and provides an inner space, in which processes are performed. An opening is defined in a center of an upper wall 140 of the chamber 100. The opening serves as a passage for taking a substrate W in or out of the chamber 100. The opening is opened or closed by a door 180. The door 180 includes a transparent window 181. Alternatively, the passage for taking the substrate W in or out may be provided in a sidewall 160 of the chamber 100.

The substrate support unit 200 includes a substrate holder 210 and a susceptor 230.

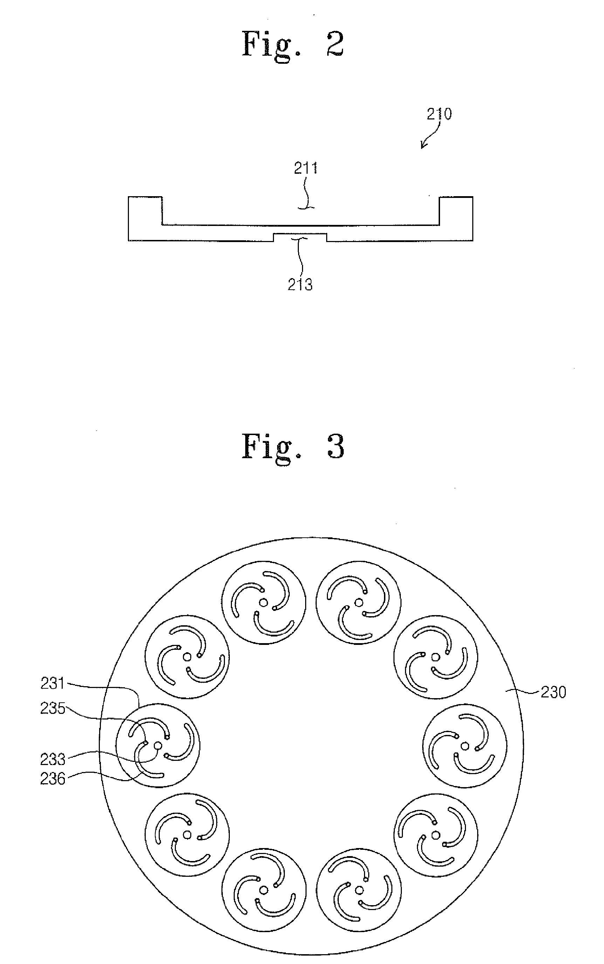

FIG. 2 is a schematic sectional view illustrating the substrate holder of FIG. 1. Referring to FIG. 2, a substrate holder 210 has a substantially circular shape. Also, a substrate seating groove 211 on which the substrate W is seated is defined in a top surface of the substrate holder 210. One substrate seating groove 211 is defined in a center of the top surface of the substrate holder 210. Alternatively, a plurality of substrate seating grooves 211 may be selectively provided in the substrate holder 210. A fixed groove 213 is defined in a center of an under surface of the substrate holder 210.

FIG. 3 is a schematic plan view illustrating the susceptor of FIG. 1. Referring to FIG. 3, the susceptor has a circular plate shape. A plurality of holder seating grooves 231 are defined in a top surface of the susceptor 230. The holder seating grooves 231 are arranged in a circular ring shape with respect to a central axis of the susceptor 230. The holder seating grooves 231 may have the same size and shape as each other. For example, each of the holder seating grooves 231 may have a circular shape, and tens holder seating grooves 231 may be provided. The holder seating grooves 231 may be spaced the same distance from each other. Each of the holder seating grooves 231 may have the same size as the substrate holder 210 or a size greater than that of the substrate holder 210. A protrusion 233 protruding upward is disposed on a central portion of a top surface of each of the holder seating grooves 231. When the substrate holder 210 is seated on the holder seating groove 231, the protrusion 233 is inserted into the fixed groove 213 of the substrate holder 210.

A plurality of injection holes 235 for injecting a gas are defined in a top surface of each of the holder seating grooves 231. For example, three injection holes may be defined in one holder seating grooves 231. Each of the injection holes 235 surrounds the protrusion 233. Also, the injection holes 235 are spaced the same distance from each other.

A guide groove 236 connected to each of the injection holes 235 is defined in the top surface of each of the holder seating grooves 231. The guide groove 236 may be rounded from the injection hole 235. The guide groove 236 guides a flow direction of the gas so that the substrate holder 210 is rotated in a state where the substrate holder 210 floats. Gas supply lines 234 are disposed in the susceptor 230. One gas supply line 234 is connected to the injection hole 235 defined in one holder seating groove 231. The gas supply lines 234 are independently disposed with respect to each other. Each of the gas supply lines 234 is connected up to the inside of a rotation shaft 250 along the inside of the susceptor 230. Also, the gas supply line 234 has an end connected to a gas storage part (not shown). Flow regulators 236 for regulating a flow rate of a gas are disposed in the gas supply lines 234, respectively. Each of the flow regulators 236 may individually regulate a flow rate of a gas supplied into each of the injection holes 235. Each of the flow regulators 236 may differently regulate the flow rate of the gas supplied into the whole or a portion of the flow regulators 236. The gas supplied into the injection hole 235 may be an inert gas such as a nitrogen gas. The susceptor 230 may be rotatably disposed with respect to a central axis thereof. The rotation shaft 250 for rotating the susceptor 230 is coupled to a center of an under surface of the susceptor 230. A motor 270 is coupled to the rotation shaft 250. Thus, a rotation force of the motor 270 is transmitted into the susceptor 230 through the rotation shaft 250.

Although ten holder seating grooves 231 and three injection holes 235 are provided in an embodiment of the inventive concept, the present disclosure is not limited thereto. For example, the number of holder seating grooves 231 and injection holes 23S may be variously changed.

Referring again to FIG. 1, the injection unit 300 includes an injection nozzle 310 and a gas supply line 350. The injection nozzle 310 supplies a process gas onto the substrate W supported by the substrate support unit 200. The injection nozzle 310 has a cylindrical shape. The injection nozzle 310 is fixed and coupled to the door 180. The injection nozzle 310 is disposed above the susceptor 230 to face the susceptor 230. The injection nozzle 310 has a width less than that of a top surface of the susceptor 230. The injection nozzle 310 and the holder seating groove 231 do not overlap each other when viewed from an upper side, A plurality of discharge holes 311 are defined in an outer surface of the injection nozzle 310. The discharge holes 311 are defined along a circumference direction of the injection nozzle 310. The discharge holes 311 are spaced the same distance from each other. The discharge holes 311 have the same size as each other. The injection nozzle 310 receives the process gas from the gas supply line 350. The process gas supplied into the injection nozzle 310 is supplied onto the substrate W through each of the discharge holes 311. A line (not shown) in which cooling water flows is disposed within the injection nozzle 310. The cooling water prevents process gases from reacting with each other within the injection nozzle 310. Also, the cooling water prevents process byproducts generated during the performance of processes from being attached to an outside wall of the injection nozzle 310.

The exhaust unit 400 includes an exhaust ring 410, an exhaust tube 430, and a pump 450. The exhaust ring 410 has a ring shape. An inner surface of the exhaust ring 410 is disposed adjacent to the susceptor 230. An outer surface of the exhaust ring 410 is disposed adjacent to a sidewall of the chamber 100. The exhaust ring 410 is disposed spaced from the susceptor 230 and the sidewall. An upper end of the exhaust ring 410 may be disposed at the same height as that of a top surface of the susceptor 230 or at a height less than that of the susceptor 230. A plurality of exhaust holes 411 is defined in the upper end of the exhaust ring 410. The exhaust holes 411 are spaced a predetermined distance from each other along a circumference direction of the exhaust ring 410. Thus, an inner space of the chamber 100 and an inner space of the exhaust ring 410 communicate with each other by the exhaust holes 411.

The exhaust tube 430 has a cylindrical shape. The exhaust tube 430 has an upper end coupled to an under surface of the exhaust ring 410 to support the exhaust ring 410. The exhaust ring 410 has a lower end connected to the pump 450.

The pump 450 adjusts an internal pressure of the chamber 10 through the exhaust ring 410 and the exhaust tube 430. Also, the pump 450 inhales the byproducts generated during the performance of the processes to discharge the byproducts to the outside.

The heater 500 is disposed under the susceptor 230. The heater 500 is spirally disposed parallel to the under surface of the susceptor 230. Heat provided by the heater 500 is transmitted into the substrate W through the susceptor 230 and the substrate holder 210.

The detection member 600 detects a state of each of the substrates W when the processes are performed. For example, the state of the substrate W may be a temperature of the substrate W. For another example, the state of the substrate W may be a thickness of a thin film deposited on each of the substrates W. The detection member 600 is disposed outside the chamber 100 to face the transparent window 181 of the door 180. The detection member 600 may be disposed directly above any position on a revolution mark along which the holder seating groove 231 is rotated. When the susceptor 230 is rotated, the detection member 600 sequentially faces each of the substrates W to detect a state of each of the substrates W along the circumference direction of the susceptor 230.

The control unit 700 receives information with respect to the state of each of the substrates W from the detection member 600 when the processes are performed. The control unit 700 controls each of the flow regulators 236 on the basis of the detected information. Thus, a flow rate of a gas supplied onto each of the substrates W may be individually regulated.

A deposition process may be performed under a high temperature condition of about 1,000°C or more. Thin films deposited on the substrates W may be different each other in deposition uniformity due to various factors. Among these, each of a temperature and rotation speed of the substrate W is one of factors having an influence on the deposition rate of the thin film deposited on the substrate W when the processes are performed. A flow rate of a gas supplied to the substrate holder 210 has an influence on a temperature and rotation speed of the substrate W. The more a flow rate of a gas supplied to the substrate holder 210 is increased, the more a temperature of the substrate W is decreased and also a rotation speed of the substrate W is increased. As a result, the thin film deposition rate of the substrate W is decreased. On the other hand, the more a flow rate of a gas supplied to the substrate holder 210 is decreased, the more a temperature of the substrate W is increased and also a rotation speed of the substrate W is decreased. As a result, the thin film deposition rate of the substrate W is increased. The control unit 700 controls a flow rate of a gas supplied onto the under surface of each of the substrate holders 210 according to a temperature of the substrate W and a thickness of the thin film deposited on the substrate W to individually control the temperature and rotation speed of the substrate W.

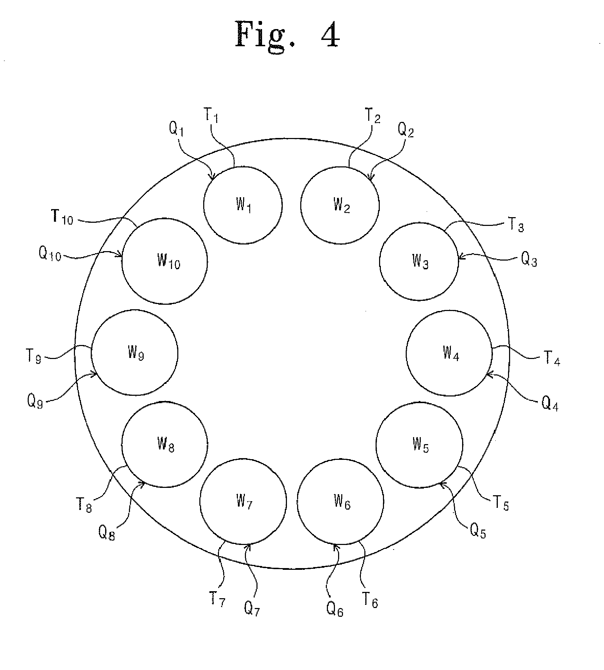

For example, the detection member 600 includes a sensor for measuring a temperature of the substrate W. FIG. 4 is a schematic view illustrating a process of supplying a gas at different flow rates according to temperatures of substrates. Referring to FIG. 4, when one substrate W₁ of a plurality of substrates W₁ to W₁₀ supported by the susceptor 230 has a temperature T₁ greater than temperatures T₂ to T₁₀ of other substrates W₂ to W₁₀, a flow rate Q₁ of a gas supplied onto the substrate holder 210 on which the substrate W₁ is placed is increased than flow rates Q₂ to Q₁₀ of the gas supplied onto the substrate holder 210 on which each of other substrates W₂ and W₁₀ is placed to decrease the temperature T₁ of the substrate W₁.

On the other hand, when one substrate W₁ of a plurality of substrates W₁ to W₁₀ supported by the susceptor 230 has a temperature T₁ less than temperatures T₂ to T₁₀ of other substrates W₂ to W₁₀, a flow rate Q₁ of a gas supplied onto the substrate holder 210 on which the substrate W₁ is placed is decreased than flow rates Q₂ to Q₁₀ of the gas supplied onto the substrate holder 210 on which each of other substrates W₂ to W₁₀ is placed to increase the temperature T₁ of the substrate W₁.

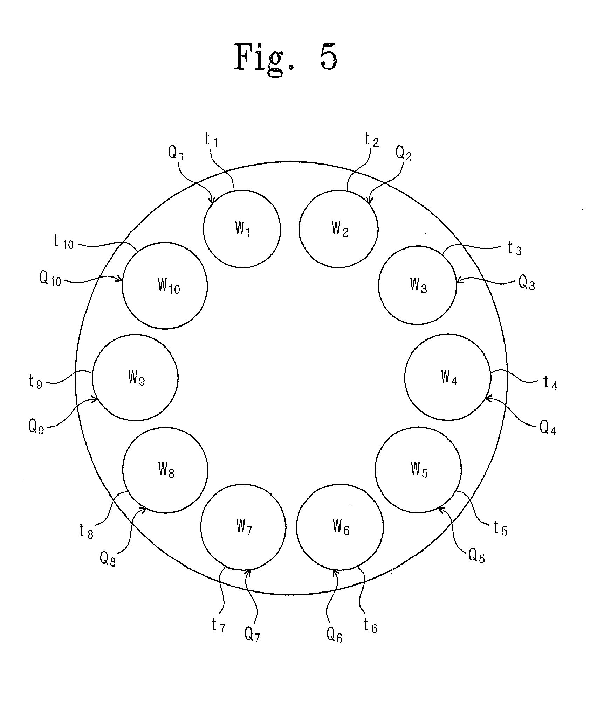

For another example, the detection member 600 includes a sensor for measuring a thickness of the thin film deposited on the substrate W. FIG. 5 is a schematic view illustrating a process of supplying a gas at different flow rates according to thicknesses of thin films deposited on substrates. Referring to FIG. 5, when a thin film deposited on one substrate W₁ of a plurality of substrates W₁ to W₁₀ supported by the susceptor 230 has a thickness t₁ greater than thicknesses t₂ to t₁₀ of other substrate W₂ to W₁₀, a flow rate Q₁ of a gas supplied onto the substrate holder 210 on which the substrate W₁ is placed is increased than flow rates Q₂ to Q₁₀ of the gas supplied onto the gas supplied onto the substrate holder 210 on which each of other substrates W₂ to W₁₀ is placed to increase a rotation speed of the substrate W₁.

On the other hand, when a thin film deposited on one substrate W₁ of a plurality of substrates W₁ to W₁₀ supported by the susceptor 230 has a thickness t₁ less than thicknesses t₂ to t₁₀ of other substrate W₂ to W₁₀, a flow rate Q₁ of a gas supplied onto the substrate holder 210 on which the substrate W₁ is placed is decreased than flow rates Q₂ to Q₁₀ of the gas supplied onto the gas supplied onto the substrate holder 210 on which each of other substrates W₂ to W₁₀ is placed to decrease a rotation speed of the substrate W₁.

According to the embodiment of the inventive concept, the deposition uniformity of the thin films deposited on the substrates supported by the susceptor may be improved.

According to the embodiment of the inventive concept, the substrates supported by the susceptor may be controlled to have the same temperature as each other.

The above-disclosed subject matter is to be considered illustrative, and not restrictive, and the appended claims are intended to cover all such modifications, enhancements, and other embodiments, which fall within the true spirit and scope of the inventive concept. Thus, to the maximum extent allowed by law, the scope of the present invention is to be determined by the broadest permissible interpretation of the following claims and their equivalents, and shall not be restricted or limited by the foregoing detailed description.

## Claims

1. An apparatus for treating substrates, the apparatus comprising:
a chamber providing an inner space in which a treatment process is performed, the chamber having an opened upper side;
a susceptor disposed within the chamber, the susceptor having a plurality of holder seating grooves in a top surface thereof, wherein an injection hole is defined in each of the holder seating grooves;
a rotation shaft rotating the susceptor;
a substrate holder on which each of the substrates is placed, the substrate holder being inserted into each of the holder seating grooves;
a heater heating the susceptor;
a gas supply line connected to the injection hole to supply a gas into the injection hole;
a flow regulator disposed on the gas supply line to regulate a flow rate of the gas;
a detection member detecting a state of each of the substrates placed on the substrate holder; and
a control unit controlling the flow regulator according to the state detected by the detection member.

2. An apparatus of claim 1, wherein the state is a temperature of each of the substrates.

3. An apparatus of claim 1, wherein the state is a thickness of a thin film deposited on each of the substrates.

4. An apparatus of any one of claims 1 to 3, wherein the holder seating grooves are arranged in a circular ring shape with respect to a central axis of the susceptor.

5. An apparatus of claim 4, wherein the detection member is disposed directly above any position on a revolution mark along which the holder seating grooves are rotated.

6. An apparatus of claim 2, wherein, when one substrate of the substrates has a temperature greater than temperatures of other substrates, the control unit increases a flow rate of a gas supplied to the substrate holder on which the one substrate is placed, and
when one substrate of the substrates has a temperature less than temperatures of other substrates, the control unit decreases a flow rate of a gas supplied to the substrate holder on which the one substrate is placed.

7. An apparatus of claim 3, wherein, when a thin film deposited on one substrate of the substrates has a thickness greater than thicknesses of thin films deposited on other substrates, the control unit increases a flow rate of a gas supplied to the substrate holder on which the one substrate is placed, and
when a thin film deposited on one substrate of the substrates has a thickness less than thicknesses of thin films deposited on other substrates, the control unit decreases a flow rate of a gas supplied to the substrate holder on which the one substrate is placed.

8. A method for treating substrates, the method comprising:
inserting a substrate holder, on which each of the substrates is placed, into each of a plurality of holder seating grooves formed in a top surface of a susceptor;
injecting a gas through an injection hole formed in each of the holder seating grooves to rotate the substrate holder, and rotating the susceptor;
detecting a state of the substrate placed on the substrate holder; and
regulating a flow rate of a gas injected onto the substrate holder according to the detected state.

9. An method of claim 8, wherein the detecting of the state comprises measuring a temperature of the substrate placed on the substrate holder.

10. An method of claim 8, wherein the detecting of the state comprises measuring a thickness of a thin film deposited on the substrate placed on the substrate holder.

11. An method of claim 9, wherein, in the regulating of the flow rate, when one substrate of the substrates has a temperature greater than temperatures of other substrates, a flow rate of a gas supplied to the substrate holder on which the one substrate is placed is increased, and
when one substrate of the substrates has a temperature less than temperatures of other substrates, a flow rate of a gas supplied to the substrate holder on which the one substrate is placed is decreased.

12. An method of claim 10, wherein, in the regulating of the flow rate, when a thin film deposited on one substrate of the substrates has a thickness greater than thicknesses of thin films deposited on other substrates, a flow rate of a gas supplied to the substrate holder on which the one substrate is placed is increased, and
when a thin film deposited on one substrate of the substrates has a thickness less than thicknesses of thin films deposited on other substrates, a flow rate of a gas supplied to the substrate holder on which the one substrate is placed is decreased.

13. A method for treating substrates, the method comprising:
forming a plurality of holder seating grooves in a top surface of a susceptor, wherein a substrate holder on which each of the substrates is placed is inserted into each of the holder seating grooves;
forming an injection hole, through which a gas is injected to rotate the substrate holder, in each of the holder seating grooves; and
supplying the gas injected through the injection hole to the whole or a portion of the respective holder seating grooves at flow rates different from each other.

14. An method of claim 13, wherein the flow rate of the gas injected through the injection hole is different according to a state of the substrate placed on the substrate holder inserted into each of the holder seating grooves.

15. An method of claim 14, wherein the state is different according to a measured temperature of each of the substrates.

16. An method of claim 14, wherein the state is different according to a measured thickness of a thin film deposited on each of the substrates.

17. An method of any one of claims 13 to 16, wherein the holder seating grooves are arranged in a circular ring shape with respect to a central axis of the susceptor, and
the states of the substrates are sequentially detected by a detection member through the rotation of the susceptor.
